# EUROPÄISCHE PATENTSCHRIFT

(11) **EP 3 232 218 B1**
(45) Veröffentlichungstag und Bekanntmachung des Hinweises auf die Patenterteilung: **22.06.2022**
(21) Anmeldenummer: 17165836.2
(22) Anmeldetag: 10.04.2017
(51) Int. Cl.: G01R 35/00, G01R 27/28

(54) **INLINE KALIBRIERMODUL, PROGRAMM-GESTEUERTE EINRICHTUNG UND KALIBRIER- UND MESS-SYSTEM**
IN-LINE CALIBRATION MODULE, PROGRAMMABLE DEVICE, AND CALIBRATION AND MEASUREMENT SYSTEM
MODULE D'ÉTALONNAGE EN LIGNE, DISPOSITIF COMMANDÉ PAR UN PROGRAMME ET SYSTÈME DE MESURE ET D'ÉTALONNAGE

(30) Priorität: 12.04.2016 DE 102016206104
(43) Veröffentlichungstag der Anmeldung: 18.10.2017
(73) Patentinhaber: Rohde & Schwarz GmbH & Co. KG, 81671 München (DE)
(72) Erfinder: Reck, Christoph, 81827 München (DE); Weber, Michael, 85748 Garching (DE); Leibfritz, Martin, 85653 Aying (DE)
(74) Vertreter: Isarpatent

(56) Entgegenhaltungen:
- CN-A- 105 044 637
- DE-A1-102005 018 073
- US-A1- 2004 150 411
- US-A1- 2005 107 972
- US-A1- 2012 072 626
- US-B1- 6 965 241

## Beschreibung

### GEBIET DER ERFINDUNG

Die vorliegende Erfindung betrifft ein Inline Kalibriermodul zur dynamischen Streuparameter-Prüfsystemkalibrierung in einer Testumgebung. Die vorliegende Erfindung betrifft ferner eine programm-gesteuerte Einrichtung sowie ein Kalibrier- und Mess-System.

### TECHNISCHER HINTERGRUND

Die vorliegende Erfindung befindet sich im Umfeld der Kalibrierung von so genannten Netzwerkanalysatoren. Ein Netzwerkanalysator, im englischen als Network Analyzer oder kurz als NWA, VNA oder NA bezeichnet, wird in der Elektronik, Nachrichtentechnik und besonders in der Hochfrequenztechnik eingesetzt, um die Streuparameter (S-Parameter), also die Wellengröße der Reflexion und Transmission an elektrischen Toren, als Funktion der Frequenz zu messen.

Anwendungen von Netzwerkanalysatoren liegen bei dem Ermitteln der Übertragungseigenschaften von beispielsweise Filtern oder Verstärkern bis hin zur Vermessung komplexer hochfrequenter Übertragungsstrecken. Als wesentliche Eigenschaft wird bei einem Netzwerkanalysator ein Messobjekt (englisch Device Under Test oder kurz DUT), beispielsweise eine elektronische Baugruppe wie ein Filter, durch im Netzwerkanalysator eingebaute Messgeneratoren (Sender) gespeist und zugleich die dabei auftretenden Signaländerungen durch Messempfänger im Netzwerkanalysator erfasst. Damit lässt sich die Messung von Sende- und Empfangssignal als relative Messung gestalten und die Messwerte zueinander in Relation setzten.

Die einzelnen Komponenten in der Messtorschaltung eines Netzwerkanalysators und der zusätzlich verwendeten Komponenten wie Messkabeln sind fehlerbehaftet. Diese Systemfehler können, sofern sie in der Messung nicht berücksichtigt werden, die ermittelten Messparameter beeinflussen. Systematischen Messabweichungen, wie Frequenz- und Phasengang des Messgeräts und der Kabel sind dadurch gekennzeichnet, dass sie reproduzierbar und zeitlich unveränderlich vorhanden sind und sich besonders bei höheren Frequenzen stark auf die Messergebnisse auswirken. Sie können aber mittels einer numerischen Systemfehlerkorrektur durch den Netzwerkanalysator weitgehend kompensiert werden.

Die Messung der systematischen Messabweichungen erfolgt im Rahmen der Kalibrierung des Netzwerkanalysators, üblicherweise unmittelbar vor der eigentlichen Messung und bei einem dem eigentlichen Messaufbau möglichst nahekommenden physischen Aufbau. Hierzu sind eigens dafür vorgesehene Kalibriermodule vorgesehen. Ein solches Kalibriermodul ist z.B. in der DE 10 2005 018 073 A1 beschrieben.

US 2005/107972 A1 beschreibt ein Kalibrierverfahren zum Testen eines Prüflings. Ein erster Port des Prüflings ist mit einem Port eines Kalibriermoduls verbunden. Ein zweiter Port des zu testenden Geräts ist mit einem ersten Port eines Gerätetesters verbunden. Ein dritter Port des zu testenden Geräts ist mit einem zweiten Port eines Gerätetesters verbunden. Der Gerätetester führt zunächst Messungen durch, um Kalibrierparameter zu erhalten.

US 2004/150411 A1 beschreibt eine elektronische Kalibrierschaltung zum Kalibrieren eines Netzwerkanalysators. Die elektronische Kalibrierungsschaltung umfasst einen Anschluss zum Koppeln der elektronischen Kalibrierungsschaltung an den Netzwerkanalysator. An den Port gekoppelte Schaltkreise können Impedanzzustände zum elektronischen Kalibrieren des Netzwerkanalysators bereitstellen.

US 6 965 241 B1 beschreibt ebenfalls ein automatisches elektronisches Kalibriergerät.

CN 105044637 A beschreibt ein Verfahren zum Testen von Mikrowellen- und Millimeterwellen-Parametern und insbesondere ein Verfahren zum Testen und Kalibrieren von Vektor-Netzwerkanalysatoren.

Für das Vermessen von hochkomplexen Messobjekten unter schwierigen Umgebungsbedingungen, wie etwa Satelliten, wird eine große Anzahl solcher Kalibriermodul benötigt. Im Allgemeinen erfolgt dabei die Steuerung der Kalibriermodule durch eine sternförmige Busverbindung zwischen einer zentralen Steuereinheit und den verschiedenen Kalibriermodulen. Für die Identifizierung der einzelnen Kalibriermodule sind diese mit einem Seriennummeraufkleber versehen und/oder die Seriennummern sind im Gehäuse der Kalibriermodule eingeschlagen. Dadurch bedingt gestaltet sich das Kalibrieren aufwändig: Zum einen ist der Verkabelungsaufwands für das sternförmige Verkabeln aufwändig, vor allem dann, wenn das Messobjekt und damit auch die verschiedenen Kalibriermodule in einer speziellen Testumgebung platziert sind. Zum anderen ist ein erhöhter Aufwand beim manuellen Eingeben der Seriennummern der jeweiligen Kalibriermodule in das zentrale Steuergerät erforderlich. Dies ist insbesondere bei einem Austausch einer oder mehrerer Kalibriermodule relevant. Nachdem die Bereitstellung derartiger Testumgebungen, wie etwa einer Testkammer zum Testen von Satelliten unter Weltraumbedingungen, nicht trivial ist, ist eine zeitaufwändige Verkabelung zugleich auch sehr kostennachteilig.

Dies ist ein Zustand, den es zu verbessern gilt.

### ZUSAMMENFASSUNG DER ERFINDUNG

Vor diesem Hintergrund liegt der vorliegenden Erfindung die Aufgabe zugrunde, eine komfortablere Kalibrierung bereitzustellen.

Erfindungsgemäß wird diese Aufgabe durch ein Kalibriermodul und/oder durch eine programm-gesteuerte Einrichtung und/oder durch ein Kalibrier- und Messsystem mit den Merkmalen der unabhängigen Patentansprüche gelöst. Weiter vorteilhafte Ausführungsformen sind Gegenstand der abhängigen Patentansprüche.

Demgemäß ist vorgesehen:
- Ein Inline-Kalibriermodul zur dynamischen Streuparameter-Prüfsystemkalibrierung in einer Testumgebung, mit mindestens drei voneinander unabhängigen, schaltbaren Kalibrierimpedanzen mit jeweils einem vorbestimmten Impedanzwert, die jeweils voneinander unabhängige Kalibrierstandards bezeichnen, mit einem Ausgang, der dazu ausgebildet ist, das Kalibriermodul mit einem zu testenden Gerät zu koppeln, mit einem als serielle Busschnittstelle ausgebildeten Steuereingang, der dazu ausgebildet ist, das Kalibriermodul zur Steuerung desselben mit einer externen Steuereinrichtung zu koppeln.
- Eine programm-gesteuerte Einrichtung, zur Steuerung von Kalibriermodulen, insbesondere von erfindungsgemäßen Inline Kalibriermodulen gemäß einem der, mit einer als serielle Busschnittstelle ausgebildete Steuerschnittstelle, mit einer Steuereinheit, die dazu ausgebildet ist, eine Vielzahl von in Daisy Chain Anordnung über die Steuerschnittstelle an der Programm-gesteuerte Einrichtung angekoppelten Kalibriermodulen zu steuern, wobei die Steuereinheit aufweist: eine Adressiereinrichtung, die dazu ausgebildet ist, die über die serielle Busschnittstelle angekoppelten Kalibriermodule anzusprechen, mit einer Analyseeinrichtung, die dazu ausgebildet ist, Informationen der jeweils angesprochenen Kalibriermodule auszulesen und/oder auszuwerten; mit einer Speichereinrichtung, die dazu ausgebildet ist, die ausgelesenen und/oder ausgewerteten Informationen abzuspeichern.
- Ein Kalibrier- und Mess-System, mit einer erfindungsgemäßen Programm-gesteuerte Einrichtung, mit mindestens zwei erfindungsgemäßen Inline Kalibriermodulen, die über deren Busschnittstelle und mittels eines seriellen Busses miteinander und mit der Programm-gesteuerten Einrichtung gekoppelt sind.

Die Erkenntnis der vorliegenden Erfindung besteht darin, dass insbesondere bei Verwendung einer großen Anzahl von Kalibriermodulen sowie einer Platzierung eines Messobjektes und somit auch der zugehörigen Kalibriermodule in einer speziellen Messumgebung, eine Punkt-zu-Punkt-Verbindung der Vielzahl von Kalibriermodulen zu einer zentralen Steuereinrichtung außerordentlich aufwändig ist und dadurch bedingt sich die Kalibrierung sehr aufwändig gestaltet.

Die der vorliegenden Erfindung zugrunde liegende Idee besteht darin, statt der bisher verwendeten Punkt-zu-Punkt-Steuerverbindung zwischen Kalibriermodulen und zentraler Steuereinrichtung nunmehr die einzelnen Kalibriermodule in Serie mit der zentralen Steuereinrichtung zu schalten. Hierzu werden mehrere Kalibriermodule am Steuerbus in einer Daisy Chain Serienanordnung kaskadiert und können so über denselben Steuerbus adressiert und damit auch gesteuert werden.

Dadurch gestaltet sich der Verkabelungsaufwand einfacher, vor allem dann wenn eine große Anzahl an Kalibriermodulen über den Steuerbus von derselben Steuereinrichtung gesteuert wird. Dies ist insbesondere vor allem dann vorteilhaft, wenn mehrere Kalibriermodule zum Beispiel jeweils in Gruppen, räumlich eng beieinander angeordnet sind. Diese können dann über relativ kurze Steuerleitungen miteinander gekoppelt werden.

Mit dem erfindungsgemäßen Inline-Kalibriermodul wird eine so genannte Inline-Kalibrierung ermöglicht, und nicht wie bei bekannten Kalibriermodulen lediglich ein Tracking, indem erfindungsgemäß eine Kalibrierung an zwei Referenzebenen des Kalibriermoduls stattfindet, nämlich an einer ersten Referenzebene am Eingang und an einer zweiten Referenzebene am Ausgang. Die Kalibrierung wird damit signifikant verbessert und vor allem genauer.

Vorteilhafte Ausgestaltungen und Weiterbildungen ergeben sich aus den weiteren Unteransprüchen sowie aus der Beschreibung unter Bezugnahme auf die Figuren der Zeichnung.

Eine bevorzugte Ausgestaltung der Erfindung sieht vor, dass die serielle Busschnittstelle eine CAN Busschnittstelle (CAN = Controller Area Network) ist. Ein CAN-Bussystem ist ein Feldbussystem, welches ursprünglich für Automobilanwendungen entwickelt wurde, um die immer komplexeren Kabelbäume in Fahrzeugen zu reduzieren und dadurch Gewicht zu sparen. Dies kann vorteilhafterweise nun auch bei der Kalibrierung von Netzwerkanalysatoren genutzt werden. Der geringere Verkabelungsaufwand spart hier Zeit bei Planung und Installation. Zudem zeichnen sich CAN-Bussysteme aufgrund deren standardisiertem Busprotokoll (OSI-Layer 1 und 2) durch eine höhere Zuverlässigkeit und bessere Verfügbarkeit durch kurze Signalwege aus. Gerade bei analogen Messsignalen erhöht sich aufgrund der im Allgemeinen verdrillten Busleitungen der Schutz vor Störungen. Da die maximale Leitungslänge mit steigenden Taktfrequenzen sinkt, werden CAN-Busse in der Regel mit geringen Taktfrequenzen betrieben. Neben CAN-Bussysteme wären auch andere Feldbussysteme denkbar, wie etwa der MOST-Bus oder der Profibus. Neben Feldbus-Systemen wären auch andere Bussysteme, wie etwa ein USB-Bus, denkbar und vorteilhaft. USB (Universal Serial Bus) bezeichnet dabei ein serielles Bussystem zur Verbindung eines Mikrocontrollers oder Computers mit mehreren externen Teilnehmern, wie etwa den Kalibriermodulen. Vorzugsweise können mit USB ausgestattete Geräte im laufenden Betrieb miteinander verbunden werden (Hot Plugging), wobei dabei angeschlossene Geräte sowie deren Eigenschaften automatisch erkannt werden.

Gemäß einer besonders bevorzugten Weiterbildung ist in dem Kalibriermodul eine modul-integrierte Speichereinrichtung vorgesehen. Die Speichereinrichtung kann z.B. als EEPROM-Lesespeicher ausgebildet sein. Denkbar wäre aber auch andere Speichertypen, wie etwa ein EPROM, ROM, DRAM, Flash-Speicher und dergleichen. In der Speichereinrichtung sind die vorbestimmten Impedanzwerte der verwendeten Kalibriestandards und/oder eine Identifikation des Kalibriermoduls abgelegt. Diese Informationen können z.B. mittels einer Anzeigeeinrichtung angezeigt oder ausgelesen werden. Auf diese Weise ist möglich, dass das Kalibriermodul dessen Seriennummer, welche z.B. in der Speichereinrichtung abgelegt ist, über den Steuerbus aktiv oder auf Anfrage der externen Steuereinrichtung an diese übertragen werden. Ein aufwändiges manuelles Einspeichern dieser Informationen in die Steuereinrichtung kann so entfallen, was für einen Anwender sehr komfortabel ist. In gleicher Weise kann eine an dem Kalibriermodul angekoppelte externe Steuereinrichtung auch die in dem Kalibriermodul abgelegten Impedanzwerte auslesen.

Eine besonders bevorzugte Weiterbildung sieht vor, dass die Speichereinrichtung ferner dazu ausgebildet ist, durch das Kalibriermodul ermittelte Kalibrier-Informationen, wie etwa einen im Zuge der Kalibrierung ermittelten Fehlerterm, und/oder über einen angeschlossenen Bus aufgenommene Adressinformationen abzuspeichern. Die durch eine vorgenommene Kalibrierung eines Ein- oder Mehrtores des Netzwerkanalysators gewonnenen Kalibrierdaten liegen damit gewissermaßen redundant nicht nur im Netzwerkanalysator sondern auch innerhalb des jeweiligen Kalibriermodul vor und können z.B. später wieder aufgerufen werden. Auch liegen innerhalb des jeweiligen Kalibriermodul die entsprechenden Adressierungsdaten, welches das Kalibriermodul über den Steuerbus von der externen Steuereinrichtung erhält, vor und können zum Beispiel mittels einer Anzeigeeinrichtung angezeigt werden.

Es existiert bekanntlich eine Reihe von unterschiedlichen Kalibrierverfahren, die sich nach den Möglichkeiten des Netzwerkanalysators, dem Aufwand und Genauigkeitsanforderungen unterscheiden. In einer typischen Ausgestaltung sind in dem Kalibriermodul die Kalibrierimpedanzen Match, Short und Open (oder kurz M, S, O) angeordnet, um eine MSO-Kalibrierung des Eintores des Netzwerkanalysators vorzunehmen. Denkbar wäre allerdings auch eine andere Art der Kalibrierung, wie etwa OSL, SOLT, TAN, TRL die drei voneinander unabhängigen Kalibrierimpedanzen bezeichnen.

In einer besonders bevorzugten Weiterbildung werden die Kalibrierstandards derart charakterisiert, dass sie Umwelteinflüsse, wie etwa Temperatur, Luftfeuchtigkeit, etc., berücksichtigen.

Besonders bevorzugt ist es, wenn das Kalibriermodul neben den mindestens drei voneinander unabhängigen, schaltbaren Kalibrierimpedanzen mit jeweils einem vorbestimmten Impedanzwert zumindest eine weitere Kalibrierimpedanz mit jeweils einem anderen vorbestimmten Impedanzwert beinhaltet. Diese weitere Kalibrierimpedanz, welche einen weiteren, von den jeweils drei Kalibrierstandards unabhängigen Kalibrierstandard unterstützt, fungiert somit gewissermaßen als Redundanz, für den Fall, dass eine vorgenommene Kalibrierung verifiziert werden soll. Diese weitere Kalibrierimpedanz dient daher als Backup-Impedanz der Sicherheit.

In einer bevorzugten Weiterbildung weist das Kalibriermodul neben den Kalibrierimpedanzen auch zumindest einen im Kalibriermodul integrierten, schaltbaren Leistungsdetektor (HF-Powermeter) auf. Damit ist für eine korrekte Darstellung der gemessenen Signale als nicht-normierte Signale neben der Systemfehlerkalibrierung auch eine Leistungskalibrierung jedes einzelnen Messtores des vektoriellen Netzwerkanalysators möglich. Vorzugsweise weist der Leistungsdetektor eine angepasste Eingangsimpedanz auf. Damit kann vorzugsweise sogar auf einen der Kalibrierstandards verzichtet werden, da der Leistungsdetektor diese Aufgabe eines weggelassenen Kalibrierstandards erfüllt. Alternativ kann dieser Leistungsdetektor auch redundant zur Verifikation der Kalibrierung verwendet werden. Mittels der Leistungsdetektoren kann sowohl die am Messobjekt anliegende Leistung, als auch die vom Messobjekt abgegebene Leistung erfasst.

In einer typischen Ausgestaltung weist das Kalibriermodul neben dem Steuereingang auch einen (Hochfrequenz-)Eingang auf. Über den (Hochfrequenz-)Eingang kann jedes einzelne Kalibriermodul durch ein geeignetes HF-Kabel direkt (oder über einen Multiplexer) mit dem Netzwerkanalysator verbunden werden, um auf diese Weise eine Streuparameter-Prüfsystemkalibrierung jedes einzelnen Mehrtores des vektoriellen Netzwerkanalysators vorzunehmen. Am (Hochfrequenz-)Ausgang ist ein Kalibriermodul mit einem zu messenden bzw. zu testenden Messobjekt verbunden.

In einer besonders bevorzugten Ausgestaltung weist das Kalibriermodul neben den schaltbaren Kalibrierimpedanzen eine schaltbare Durchverbindung zwischen dem (Hochfrequenz)Eingang und dem (Hochfrequenz-)Ausgang des Kalibriermoduls auf. Am Ausgang jedes Kalibriermoduls muss eine Referenzebene definiert und Systemfehlerkorrekturdaten aufgenommen sein. Hierzu ist neben der Kalibrierung am Eingang auch eine weitere Kalibrierung am Ausgang eines Kalibriermoduls erforderlich. Mittels der vorliegenden erfindungsgemäßen Lösung werden für diese Kalibrieraufgabe vorteilhafterweise die Kalibriermodule selbst herangezogen. Zu diesem Zweck werden die Kalibrierstandards im Kalibriermodul umgeschaltet, um z.B. eine Eintorkalibrierung (OSM bzw. OSL) zu erreichen. Zur Aufnahme der Kalibrierdaten für Transmissionsmessungen müssen die Kalibriermodule dann lediglich noch mit einer Durchverbindung, welche auch nicht ideal sein muss, verbunden werden. Mittels dieser Ausgestaltung lassen sich vorteilhafterweise auch Mehrtorsysteme vollständig kalibrieren. Bisher bekannte Lösungen verwenden nur ein so genanntes Tracking-System, bei dem der Bediener unter Zuhilfenahme eigener Kalibrierstandards das System kalibrieren muss und anschließend lediglich die Abweichungen davon detektieren und korrigieren kann. Die eben genannte erfindungsgemäße Lösung kann demgegenüber mittels desselben Kalibriermoduls sowohl ein Tracking als auch eine Kalibrierung vornehmen.

In einer weiteren bevorzugten Ausgestaltung umfasst das Kalibriermodul eine steuerbare Schaltvorrichtung. Diese steuerbare Schaltvorrichtung umfasst mehrere Betriebsmodi: In einem ersten Betriebsmodus verbindet die steuerbare Schaltvorrichtung, zum Beispiel gesteuert über die externe Steuereinrichtung und/oder der internen Steuereinrichtung des Kalibriermoduls, abwechselnd die Kalibrierimpedanzen mit dem Eingang. In einem zweiten Betriebsmodus verbindet die Schaltvorrichtung den Eingang über die Durchverbindung mit dem Ausgang. Das erfindungsgemäße Kalibriermodul stellt somit ein kombiniertes Tracking- und Kalibriermodul dar, welches somit in seiner Funktion erweitert ist.

Vorzugsweise weist ein Kalibriermodul eine Anzeigevorrichtung auf. Mittels der Anzeigevorrichtung können ID-Informationen des Kalibriermoduls, Busadressier-Informationen, empfangene oder gemessene Kalibrierdaten und/oder Informationen über den jeweils verwendeten Kalibrierstandard direkt am Kalibriermodul angezeigt werden. Mittels der Anzeigevorrichtung kann der Bediener zum Beispiel auch die Kalibrierergebnisse oder den Fortschritt einer Kalibrierung direkt am Kalibriermodul sehen, ohne dass er hierzu zu dem Netzwerkanalysator zurückkehren muss und damit aus der Testkammer gehen muss. Ebenfalls denkbar ist, dass an der Anzeigeeinrichtung angezeigt wird, mit welchen anderen Kalibriermodulen das jeweilige Kalibriermodul direkt oder indirekt verbunden ist. Die Anzeigevorrichtung kann z.B. ein Display, ein Bildschirm, ein Monitor, eine LCD-Anzeige, ein oder mehrere LED und dergleichen sein. Denkbar wäre auch eine akustische Signalisierung.

Weiter bevorzugt weist ein Kalibriermodul eine Eingabevorrichtung auf. Mittels der Eingabevorrichtung können Status-Informationen über einen aktuell verwendeten Kalibriervorgang, eine Information über den jeweils verwendeten Kalibrierstandard oder auch andere Informationen in das Kalibriermodul eingegeben werden. Die Eingabevorrichtung kann z.B. eine Tastatur, eine Taste, ein Touchpad oder dergleichen sein. Denkbar wäre auch eine akustische Eingabe unter Verwendung eines Mikrofons und eines Spracherkennungsprogramms. Mittels der Eingabevorrichtung kann der Bediener zum Beispiel direkt am Kalibriermodul eingeben, dass eine Kalibrierung zu erfolgen hat, bereits erfolgt ist oder nochmals durchgeführt werden soll. Der Bediener kann damit eine Vielzahl von Kalibriervorgängen durchführen, ohne dass er hierzu zu dem jeweiligen Netzwerkanalysator zurückkehren muss und damit aus der Testkammer gehen muss.

In einer besonders bevorzugten Ausgestaltung ist das Kalibriermodul dazu ausgebildet, die dynamische Streuparameter-Prüfsystemkalibrierung in einer zum Testen von Luft- und Raumfahrteinrichtungen geeigneten Testumgebung vorzunehmen. Eine solche Testumgebung sieht zum Beispiel eine Thermo-Vakuumkammer vor, welche zum Beispiel in einem Temperaturbereich im Bereich zwischen -40°C bis 80°C betrieben werden kann. Solche Testkammern werden zum Beispiel zum Testen von Satelliten, Satellitenkomponenten und dergleichen eingesetzt. Das Herstellen einer solchen Testumgebung und Testbedingungen innerhalb der Testkammer, insbesondere der entsprechenden Vakuumbedingungen, ist besonders zeit- und kostenaufwändig. Für das Testen von Satelliten werden darüber hinaus eine große Vielzahl von Kalibriermodulen, zum Beispiel bis zu 150 Kalibriermodule, verwendet. Vor diesem Hintergrund ist die vorliegende Erfindung vor allem für derartige Anwendungen besonders vorteilhaft, da zum Beispiel das Installieren und Verkabeln der Kalibriermodule oder etwa ein Austausch eines oder mehrerer Kalibriermodule sehr schnell und damit kostenoptimiert vonstattengehen kann.

Eine Weiterbildung sieht vor, dass ein erfindungsgemäßes Kalibriermodul eine metallische Gehäusestruktur aufweist, welche unter Testbedingungen, wie etwa der eben genannten Thermo-Vakuumbedingungen, mechanisch stressbeständig ist. Dadurch ist das Kalibriermodul weniger ausfallanfälliger und das Kalibrieren und Testen kann noch effizienter gestaltet werden. Zudem erzeugt das Kalibriermodul keinen mechanischen Stress auf die (Keramik-)Struktur eines zu messenden Testobjektes.

Gemäß einer bevorzugten Ausgestaltung der programm-gesteuerten Einrichtung ist die Adressiereinrichtung dazu ausgebildet, die jeweiligen Adressen von über die serielle Busschnittstelle angekoppelten Kalibriermodulen, welche in deren Speichereinrichtung abgelegt sind, auszulesen. Zusätzlich oder alternativ ist die Adressiereinrichtung dazu ausgebildet, den über die serielle Busschnittstelle angekoppelten Kalibriermodulen jeweils eine individuelle, dynamische Adresse zuzuweisen. Dadurch lassen sich das Kalibriermodul und dessen Funktion mittels der programm-gesteuerten Einrichtung sehr einfach steuern. Die programm-gesteuerte Einrichtung kann z.B. ein Mikrocontroller, ein Mikrocomputer, ein Steuergerät oder dergleichen sein.

Vorzugsweise ist die Analyseeinrichtung der programm-gesteuerten Einrichtung dazu ausgebildet, einen Impedanzwert aus einem über die serielle Busschnittstelle angekoppelten Kalibriermodul auszulesen. Dies schafft eine zusätzliche Sicherheit. Zusätzlich oder alternativ können auch lediglich die Prüfsumme und damit eine reduzierte Datenmenge eines jeweiligen Impedanzwertes ausgelesen werten.

Gemäß einer besonders bevorzugten Ausgestaltung der programm-gesteuerten Einrichtung weist diese eine Anzeigevorrichtung auf. Mittels dieser Anzeigevorrichtung lassen sich eine Information eines über die serielle Busschnittstelle angekoppelten Kalibriermoduls, wie etwa dessen Adresse, dessen Impedanzwerte der verwendeten Kalibrierstandards, deren Status und/oder deren Betriebsmodi, angezeigt werden.

Das Kalibrier- und Mess-System umfasst einen Netzwerkanalysator, der über eine Vielzahl von Messleitungen mit jeweiligen Eingängen der Kalibriermodule verbunden ist und der in einem ersten Betriebsmodus dazu ausgebildet ist, durch die Kalibriermodule kalibriert zu werden. Vorzugsweise ist der Netzwerkanalysator dazu ausgebildet, zur dynamischen Streuparameter-Prüfsystemkalibrierung eine Eintorkalibrierung am Eingang und/oder am Ausgang des Kalibriermoduls durchzuführen. Zusätzlich kann auch eine Mehrtorkalibrierung vorgenommen werden, wenngleich diese sich auch deutlich rechenaufwändiger gestaltet.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnungen angegebenen Ausführungsbeispiele näher erläutert. Es zeigen dabei:
- Fig. 1: ein erstes, allgemeines Ausführungsbeispiel eines erfindungsgemäßen Kalibriermoduls;
- Fig. 2: ein Ausführungsbeispiel einer Daisy Chain Anordnung einer erfindungsgemäßen Steuereinrichtung und einer Vielzahl von erfindungsgemäßen Kalibriermodulen;
- Fig. 3: ein zweites, bevorzugtes Ausführungsbeispiel eines erfindungsgemäßen Kalibriermoduls;
- Fig. 4: ein Ausführungsbeispiel einer erfindungsgemäßen programm-gesteuerten Einrichtung zur Steuerung einer Vielzahl von erfindungsgemäßen Kalibriermodulen;
- Fig. 5: ein Ausführungsbeispiel eines erfindungsgemäßen Kalibrier- und Mess-Systems;
- Fig. 6: ein Ausführungsbeispiel eines erfindungsgemäßen Kalibriermodul zur Erläuterung von bevorzugten Betriebsmodi.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts Anderes ausführt ist -jeweils mit denselben Bezugszeichen versehen.

### BESCHREIBUNG VON AUSFÜHRUNGSBEISPIELEN

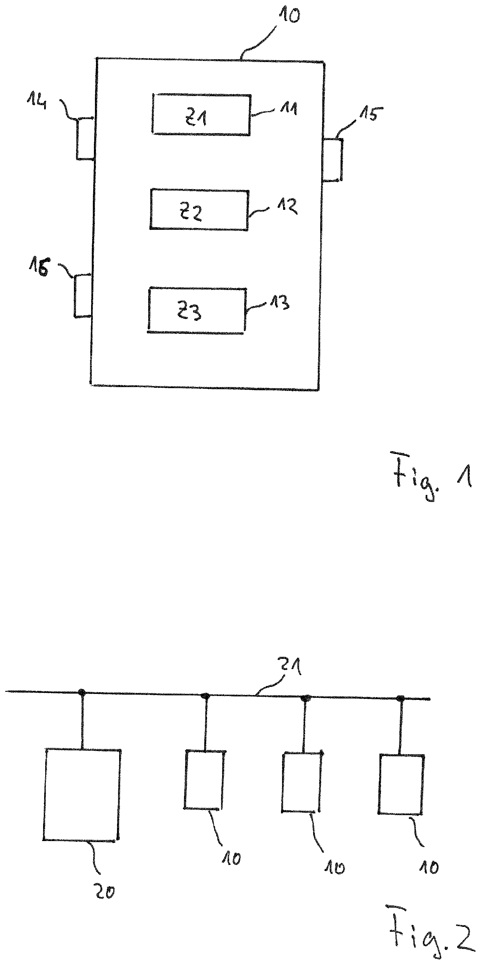

Fig. 1 zeigt ein erstes, allgemeines Ausführungsbeispiel eines erfindungsgemäßen Inline Kalibriermoduls zur dynamischen Streuparameter-Prüfsystemkalibrierung.

Das Inline Kalibriermodul ist hier mit Bezugszeichen 10 bezeichnet. Das Kalibriermodul 10 umfasst drei voneinander unabhängige, schaltbare Kalibrierimpedanzen 11, 12, 13 mit jeweils einem vorbestimmten Impedanzwert Z1, Z2, Z3, die jeweils voneinander unabhängige Kalibrierstandards bezeichnen. Beispielsweise bezeichnet die Kalibrierimpedanz 11 mit dem Impedanzwert Z1 den Kalibrierstandard Match (kurz M). Bei der Match-Kalibrierung (deutsch: Angepasst) wird die Messleitung mit dem Leitungswellenwiderstand abgeschlossen. Ist das Messtor mit seinem Wellenwiderstand abgeschlossen, treten keine Signalreflexionen auf. Im Smith-Diagramm definiert der Match den Punkt Eins auf der X-Achse, das heißt den Mittelpunkt des Diagrammes. Dieser Punkt wird im Zusammenhang mit Netzwerkanalysatoren auch häufig mit dem Begriff Systemimpedanz bezeichnet.

Die Kalibrierimpedanz 12 mit dem Impedanzwert Z2 kann beispielsweise den Kalibrierstandard Short (kurz S) bezeichnen. Bei einem Kalibrierstandard Short (deutsch: Kurzschluss) ist die Messleitung definiert mit der Leitungsschirmung (Masse) verbunden, d. h. kurzgeschlossen. Ein kurzgeschlossenes Leitungsende bewirkt ebenfalls eine Totalreflexion des gesendeten Signals, jedoch ist die Phase des Signals gegenüber den Open um 180° gedreht. Im Smith-Diagramm definiert der Short den Punkt Null auf der X-Achse.

Die Kalibrierimpedanz 13 mit dem Impedanzwert Z3 kann beispielsweise den Open (kurz O) bezeichnen. Bei einem Kalibrierstandard Open (deutsch: Offen) ist die Messleitung definiert offen, das heißt mit nichts verbunden (entspricht elektrisch dem Leerlauf. Ein offenes Leitungsende bewirkt eine Totalreflexion des gesendeten Signals. Betrachtet man die komplexen Daten einer Reflexionsmessung an einem Tor des Netzwerkanalysators im Smith-Diagramm, so definiert der Open den Punkt Unendlich auf der X-Achse.

Mit den eben genannten Kalibrierstandards M, S, O ist eine so genannte MSO-Kalibrierung des Netzwerkanalysators möglich. Daneben wäre auch andere Kalibrierstandards, wie etwa Through (T), Reflect (R), Attenuation (A), Line (L) für andere Kalibrierarten denkbar.

Das Kalibriermodul 10 umfasst ferner einen Hochfrequenzeingang 14 und einem Hochfrequenzausgang 15. Der Hochfrequenzeingang 14 definiert eine Eingangsschnittstelle, über den das Kalibriermodul 10 direkt oder mittels eines Multiplexers mit entsprechenden hochfrequenten Anschlüssen eines (hier nicht gezeigten) Netzwerkanalysators koppelbar ist. Über diese Schnittstelle 14, die eine erste Referenzebene der Kalibrierung definiert, kann der Netzwerkanalysator anhand einer Streuparameter-Prüfsystemkalibrierung kalibriert werden. Der Hochfrequenzausgang 15 definiert eine Ausgangsschnittstelle, über den das Kalibriermodul 10 mit einem zu testenden (hier nicht gezeigten) Messobjekt koppelbar ist. Diese Schnittstelle 15 definiert eine zweite Referenzebene der Kalibrierung.

Das Kalibriermodul 10 enthält ferner einen Steuereingang 16. Der Steuereingang 16 definiert eine Steuerschnittstelle, über den das Kalibriermodul 10 direkt oder indirekt mit einer (hier nicht gezeigten) Steuereinrichtung, welche der Steuerung des Kalibriermoduls 10 dient, koppelbar ist.

Erfindungsgemäß ist der Steuereingang 16 als serielle Busschnittstelle 16 ausgebildet. Auf diese Weise lassen sich eine Vielzahl von im Wesentlichen gleichartigen Kalibriermodule 10 in einer seriellen Daisy Chain Buskonfiguration mit einer externen Steuereinrichtung 20 koppeln, wie dies in der Figur 2 dargestellt ist. Die Verbindungen zwischen den Kalibriermodulen 10 untereinander und der Steuereinrichtung 20 definiert dann einen Steuerbus 21, der an jeweiligen Steuereingängen der Kalibriermodule 10 angekoppelt ist. Mittels dieser seriellen Daisy Chain Anordnung lässt sich ein erheblicher Verkabelungsaufwand für die Steuerleitungen 21 einsparen.

Die Steuereinrichtung 20 dient der Steuerung der Vielzahl von Kalibriermodulen 10. Beispielsweise kann die Steuereinrichtung als Master fungieren, welche den Zugriff der Kalibriermodule 10 auf den Steuerbus 21 steuert, indem die Steuereinrichtung 20 zum Beispiel den Kalibriermodule 10 jeweilige Adressen zu-teilt und/oder mit diesen eine Adressierung aushandelt.

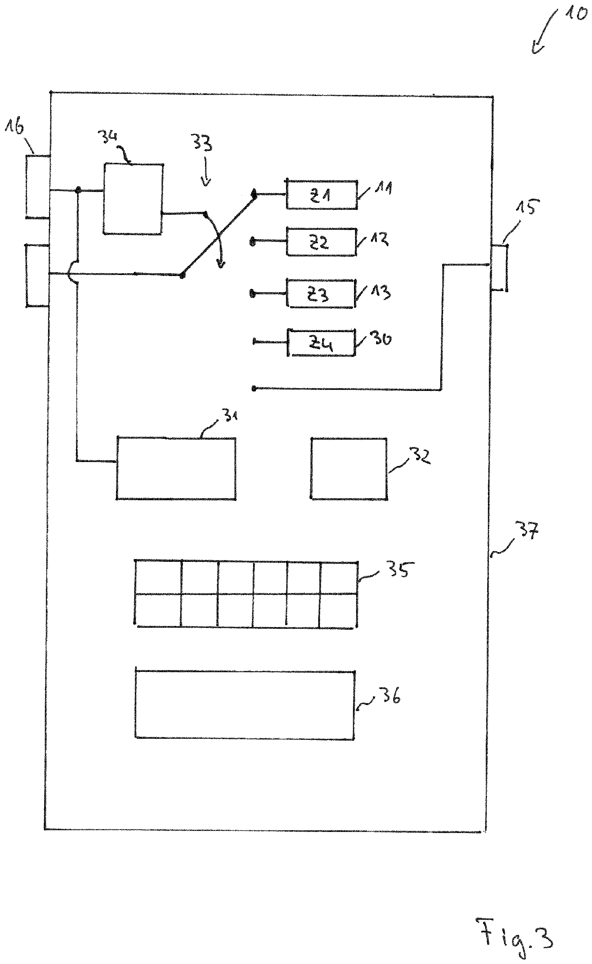

Fig. 3 zeigt ein zweites, bevorzugtes Ausführungsbeispiel eines erfindungsgemäßen Kalibriermoduls.

Das Kalibriermodul 10 umfasst neben den drei Kalibrierimpedanzen 11, 12, 13 in diesem Beispiel noch eine weitere Kalibrierimpedanz 30 mit dem Impedanzwert Z4, welche einen weiteren, von den jeweils drei ohnehin verwendeten Kalibrierstandards M,S, O unabhängigen Kalibrierstandard unterstützt. Vorzugsweise sind dabei einzelne oder alle Kalibrierstandards dazu ausgebildeten, spezielle Umwelteinflüsse, wie etwa Druck, Temperatur, Feuchtigkeit, etc. zu berücksichtigen.

Das Kalibriermodul 10 umfasst eine integrierte Speichereinrichtung 31. In der Speichereinrichtung 31 können eine Vielzahl von Adress-, Steuer- und/ oder Messdaten abgelegt werden, wie etwa:
- die Impedanzwerte Z1, Z2, Z3 der Kalibrierimpedanzen 11, 12, 13;
- eine Identifikation des Kalibriermoduls 10, beispielsweise dessen Seriennummer, welche zum Beispiel auch in dem Gehäuse aufgedruckt, eingestanzt oder aufgeklebt ist;
- durch das Kalibriermodul 10 ermittelte Kalibrier-Informationen des kalibrierten Netzwerkanalysators;
- über einen Steuerbus 21 aufgenommene Adressinformationen, welche das Kalibriermoduls 10 z.B. von der Steuereinrichtung 20 erhalten hat oder mit dieser ausgehandelt hat;
- Informationen, welche weiteren Kalibriermodule 10 direkt oder indirekt angeschlossen sind.

Das Kalibriermodul 10 umfasst ferner einen integrierten schaltbaren Leistungsdetektor 32. Mittels des Leistungsdetektors 32 lassen sich sowohl die an einem Messobjekt anliegende Leistung, als auch die vom Messobjekt abgegebene Leistung erfassen, sodass darauf auf geeignete Weise reagiert werden kann.

Das Kalibriermodul 10 umfasst ferner eine steuerbare Schaltvorrichtung 33. Mittels der Schaltvorrichtung 33, welche zum Beispiel über eine Kalibriermodul-interen Steuereinrichtung 34 gesteuert wird, können die verschiedenen Kalibrierimpedanzen des Kalibriermoduls 10 geschaltet werden. Damit können nacheinander die Kalibrierungen anhand des jeweils geschalteten Kalibrierstandards vorgenommen werden.

Das Kalibriermodul 10 weist ferner eine Anzeigevorrichtung 35 auf. Mittels der Anzeigevorrichtung 35, welche zum Beispiel als Display ausgebildet ist, können in der Speichereinrichtung 31 abgelegte Informationen z.B. bedarfsweise angezeigt werden. Beispielsweise können ID-Informationen des Kalibriermoduls 10, Busadressier-Informationen, empfangene oder gemessene Kalibrierdaten und/oder Informationen über den jeweils verwendeten Kalibrierstandard angezeigt werden.

Das Kalibriermodul 10 weist ferner eine Eingabevorrichtung 36 auf, welche z. B. eine Taste, Tastatur oder dergleichen sein kann. Mittels der Eingabevorrichtung 36 kann ein Bediener benutzerspezifische Eingaben, wie etwa Status-Informationen über einen aktuell verwendeten Kalibriervorgang tätigen.

Das Kalibriermodul 10 weist ferner ein Gehäuse 37 auf. Dieses Gehäuse 37 ist vorzugsweise metallisch, um so unter Testbedingen mechanisch stressbeständig zu sein.

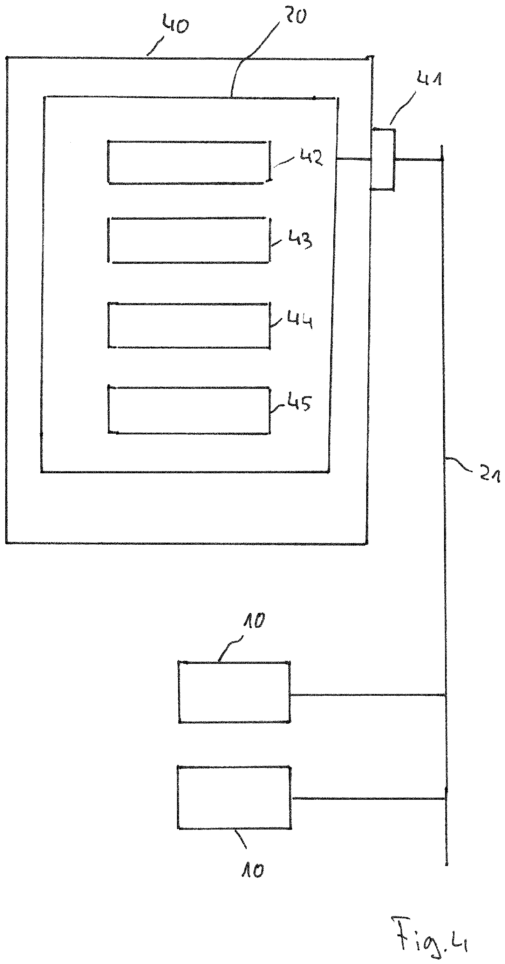

Fig. 4 zeigt ein Ausführungsbeispiel einer erfindungsgemäßen programm-gesteuerten Einrichtung zur Steuerung einer Vielzahl von erfindungsgemäßen Kalibriermodulen.

Die mit Bezugszeichen 40 bezeichnete programm-gesteuerte Einrichtung umfasst die Funktion der bereits anhand der Figur 2 erläuterten als Steuereinrichtung 30. Die programm-gesteuerte Einrichtung 40 ist somit in Daisy Chain-Anordnung mit einer Vielzahl von Kalibriermodulen 10 verbunden. Die programm-gesteuerte Einrichtung 40 umfasst ferner eine als serielle Busschnittstelle ausgebildete Steuerschnittstelle 41. Zur Steuerung der Vielzahl von in Daisy Chain Anordnung über die Steuerschnittstelle 41 angekoppelten Kalibriermodule 10 weist die Steuereinrichtung 30 Folgendes auf:
Eine Adressiereinrichtung 42, die dazu ausgebildet ist, die über die serielle Busschnittstelle angekoppelten Kalibriermodule 10 anzusprechen. Die Adressiereinrichtung 42 ist z.B. dazu ausgebildet, Adressen von über die serielle Busschnittstelle angekoppelten Kalibriermodulen auszulesen und/oder den über die serielle Busschnittstelle angekoppelten Kalibriermodulen 10 jeweils eine individuelle, dynamische Adresse zuzuweisen.

Eine Analyseeinrichtung 43, die dazu ausgebildet ist, Informationen der jeweils angesprochenen Kalibriermodule 10 auszulesen und/oder auszuwerten. Die Analyseeinrichtung 43 kann ferner dazu ausgebildet sein, automatisch einen Impedanzwert und/oder eine Prüfsumme eines jeweiligen Impedanzwertes aus einem über die serielle Busschnittstelle angekoppelten Kalibriermodul 10 auszulesen.

Eine Speichereinrichtung 44, die dazu ausgebildet ist, die ausgelesenen und/oder ausgewerteten Informationen abzuspeichern.

Eine Anzeigevorrichtung 45, die dazu ausgebildet ist, eine Information der über die serielle Busschnittstelle angekoppelten Kalibriermodule 10, deren Status und/oder deren Betriebsmodi anzuzeigen.

Die programm-gesteuerte Einrichtung 40 kann beispielsweise ein Mikrocontroller sein oder beinhalten, welcher in einem eigens dafür vorgesehenen Steuergerät (hier nicht angezeigt) implementiert ist.

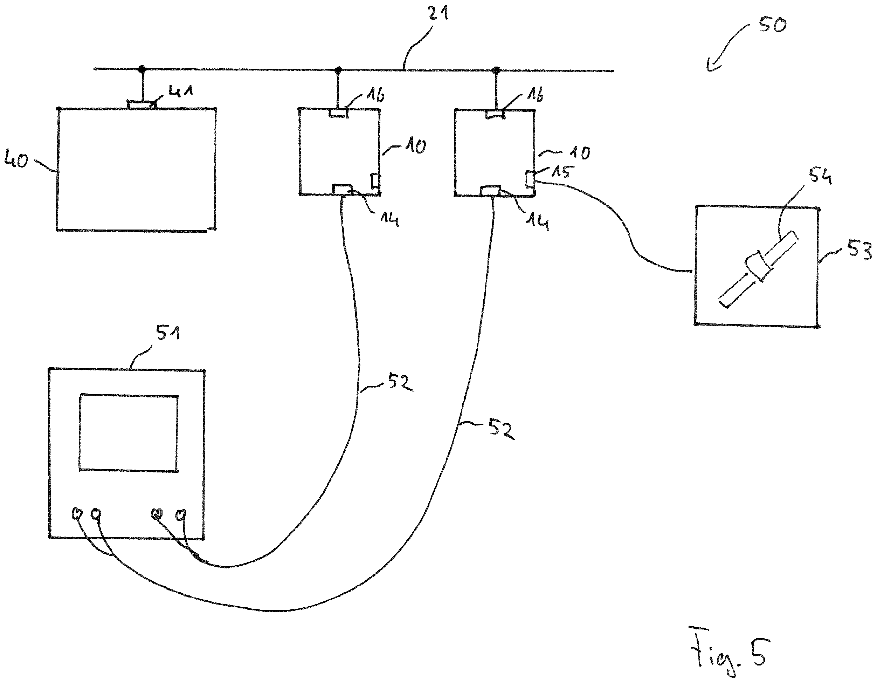

Fig. 5 zeigt ein Ausführungsbeispiel eines erfindungsgemäßen Kalibrier- und Mess-Systems.

Das mit Bezugszeichen 50 bezeichnete Kalibrier- und Mess-System umfasst eine programm-gesteuerte Einrichtung 40, mindestens zwei Kalibriermodule 10, die über deren Busschnittstelle und mittels eines seriellen Busses miteinander und mit der programm-gesteuerten Einrichtung 40 gekoppelt sind, sowie einen Netzwerkanalysator 51. Der Netzwerkanalysator 51 ist über eine Vielzahl von Messleitungen 52 mit jeweiligen Eingängen 14 der Kalibriermodule 10 verbunden. Die Eingänge des Netzwerkanalysators 51 können damit mittels der Kalibriermodule 10 kalibriert werden.

Die Kalibriermodule 10 sind über deren Ausgänge 15 mit einer Testkammer 53 verbunden, in welcher zum Beispiel ein als Satellit ausgebildetes Testobjekt 54 angeordnet ist. Das Testobjekt 54 ist in einer zum Testen von Luft- und Raumfahrteinrichtungen geeigneten Testumgebung angeordnet.

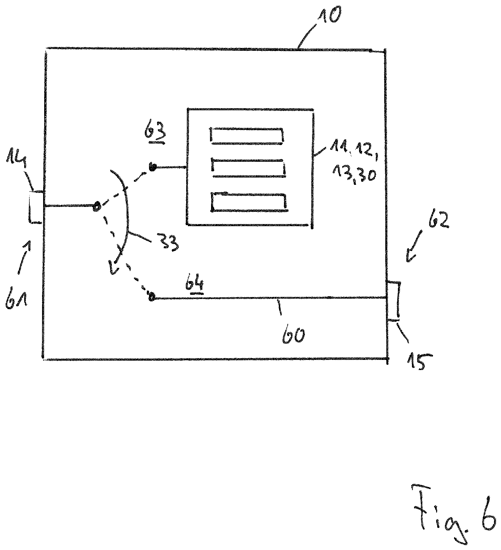

Fig. 6 zeigt ein Ausführungsbeispiel eines erfindungsgemäßen Kalibriermoduls zur Erläuterung von bevorzugten Betriebsmodi.

Das Kalibriermodul 10 weist hier neben den mittels der Schaltvorrichtung 33 schaltbaren Kalibrierimpedanzen 11, 12, 13, 30 eine schaltbare Durchverbindung 60 auf. Diese Durchverbindung 60 ist zwischen dem Eingang 14 und dem Ausgang 15 geschaltet. In einem ersten Betriebsmodus 63 können auf diese Weise abwechselnd die Kalibrierimpedanzen 11, 12, 13, 30 mit dem Eingang 14 verbunden werden. In einem zweiten Betriebsmodus 64 kann der Eingang 14 über die Durchverbindung 60 direkt auf den Ausgang 15 geschaltet werden. Damit erhält man zwei Referenzebenen 61, 62 für die Kalibrierung, nämlich eine erste Referenzebene 61 am Eingang 14 und eine zweite Referenzebene 62 am Ausgang 15. Die Kalibrierung wird damit genauer.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

### Bezugszeichenliste

- 10: Inline-Kalibriermodul
- 11 - 13: voneinander unabhängige, schaltbare Kalibrierimpedanzen
- 14: (Hochfrequenz)Eingang, Eingangsschnittstelle
- 15: (Hochfrequenz-)Ausgang, Ausgangsschnittstelle
- 16: Steuereingang, Steuerschnittstelle

- 20: Steuereinrichtung
- 21: Steuerbus

- 30: weitere Kalibrierimpedanz
- 31: Speichereinrichtung
- 32: Leistungsdetektor
- 33: Schaltvorrichtung
- 34: Steuereinrichtung
- 35: Anzeigevorrichtung
- 36: Eingabevorrichtung
- 37: Gehäuse

- 40: programm-gesteuerte Einrichtung, Mikrocontroller
- 41: Steuerschnittstelle
- 42: Adressiereinrichtung
- 43: Analyseeinrichtung
- 44: Speichereinrichtung
- 45: Anzeigevorrichtung

- 50: Kalibrier- und Mess-System
- 51: Netzwerkanalysator
- 52: Messleitungen
- 53: (Thermo-Vakuum-)Testkammer
- 54: Testobjekt
- 60: Durchverbindung
- 61: Referenzebene
- 62: Referen

## Patentansprüche

1. Inline Kalibriermodul zur dynamischen Streuparameter-Prüfsystemkalibrierung in einer Testumgebung,
mit mindestens drei voneinander unabhängigen, schaltbaren Kalibrierimpedanzen mit jeweils einem vorbestimmten Impedanzwert, die jeweils voneinander unabhängige Kalibrierstandards bezeichnen,
mit einem Ausgang, der dazu ausgebildet ist, das Kalibriermodul mit einem zu testenden Gerät zu koppeln,
mit einem als serielle Busschnittstelle ausgebildeten Steuereingang, der dazu ausgebildet ist, das Kalibriermodul zur Steuerung desselben mit einer externen Steuereinrichtung zu koppeln.

2. Kalibriermodul nach Anspruch 1,
**dadurch gekennzeichnet,**
**dass** die serielle Busschnittstelle eine CAN Busschnittstelle oder USB-Busschnittstelle ist.

3. Kalibriermodul nach einem der vorherigen Ansprüche, **dadurch gekennzeichnet,**
**dass** eine Speichereinrichtung vorhanden ist, in welcher die vorbestimmten Impedanzwerte und/oder eine Identifikation des Kalibriermoduls abgelegt sind.

4. Kalibriermodul nach Anspruch 3,
**dadurch gekennzeichnet,**
**dass** die Speichereinrichtung ferner dazu ausgebildet ist, durch das Kalibriermodul ermittelte Kalibrier-Informationen und/oder über einen angeschlossenen Bus aufgenommene Adressinformationen abzuspeichern.

5. Kalibriermodul nach einem der vorherigen Ansprüche, **dadurch gekennzeichnet,**
**dass** die drei voneinander unabhängigen Kalibrierimpedanzen Open, Short und Match bezeichnen, und/oder dass die Kalibrierstandards dazu ausgebildeten sind, Umwelteinflüsse zu berücksichtigen, und/oder dass zumindest eine weitere Kalibrierimpedanz mit jeweils einem vorbestimmten Impedanzwert vorhanden ist, die einen weiteren, von den jeweils drei Kalibrierstandards unabhängigen Kalibrierstandard unterstützt.

6. Kalibriermodul nach einem der vorherigen Ansprüche, **dadurch gekennzeichnet,**
**dass** ein integrierter schaltbarer Leistungsdetektor vorhanden ist.

7. Kalibriermodul nach einem der vorherigen Ansprüche, **dadurch gekennzeichnet,**
**dass** eine Anzeigevorrichtung, insbesondere ein Display, vorhanden ist, welche dazu ausgebildet ist, ID-Informationen des Kalibriermoduls, Busadressier-Informationen, empfangene oder gemessene Kalibrierdaten und/oder Informationen über den jeweils verwendeten Kalibrierstandard anzuzeigen, und/oder dass eine Eingabevorrichtung, insbesondere ein Taste oder eine Tastatur, vorhanden ist, welche dazu ausgebildet ist, Status-Informationen über einen aktuell verwendeten Kalibriervorgang und/oder eine Information über den jeweils verwendeten Kalibrierstandard einzugeben.

8. Kalibriermodul nach einem der vorherigen Ansprüche, **dadurch gekennzeichnet,**
**dass** das Kalibriermodul eine metallische Gehäusestruktur aufweist, welche derart ausgebildet ist, dass sie unter Testbedingen mechanisch stressbeständig ist.

9. Kalibriermodul nach einem der vorherigen Ansprüche, **dadurch gekennzeichnet,**
**dass** ein Eingang vorhanden ist, der dazu ausgebildet ist, das Kalibriermodul mit einem Netzwerkanalysator für eine Streuparameter-Prüfsystemkalibrierung zu koppeln.

10. Kalibriermodul nach Anspruch 9,
**dadurch gekennzeichnet,**
**dass** das Kalibriermodul neben den schaltbaren Kalibrierimpedanzen eine schaltbare Durchverbindung zwischen dem Eingang und dem Ausgang aufweist, dass insbesondere eine steuerbare Schaltvorrichtung vorhanden ist, welche in einem ersten Betriebsmodus abwechselnd die Kalibrierimpedanzen mit dem Eingang verbindet und welche in einem zweiten Betriebsmodus den Eingang über die Durchverbindung mit dem Ausgang verbindet.

11. System umfassend ein Kalibriermodul nach einem der Ansprüche 1 bis 8 und einer programm-gesteuerten
Einrichtung zur Steuerung des Kalibriermoduls,
wobei das Kalibriermodul einen Eingang aufweist, der dazu ausgebildet ist, das Kalibriermodul mit einem Netzwerkanalysator für eine Streuparameter-Prüfsystemkalibrierung zu koppeln, und
wobei das Kalibriermodul neben den schaltbaren Kalibrierimpedanzen eine schaltbare Durchverbindung zwischen dem Eingang und dem Ausgang aufweist, und wobei insbesondere eine steuerbare Schaltvorrichtung vorhanden ist, welche in einem ersten Betriebsmodus abwechselnd die Kalibrierimpedanzen mit dem Eingang verbindet und welche in einem zweiten Betriebsmodus den Eingang über die Durchverbindung mit dem Ausgang verbindet,
wobei die programm-gesteuerte Einrichtung folgendes umfasst:
eine als serielle Busschnittstelle ausgebildete Steuerschnittstelle,
eine Steuereinheit, die dazu ausgebildet ist, eine Vielzahl von in Daisy Chain Anordnung über die Steuerschnittstelle an der Programm-gesteuerte Einrichtung angekoppelten Kalibriermodulen zu steuern, wobei die Steuereinheit eine Adressiereinrichtung aufweist, die dazu ausgebildet ist, die über die serielle Busschnittstelle angekoppelten Kalibriermodule anzusprechen,
eine Analyseeinrichtung, die dazu ausgebildet ist, Informationen der jeweils angesprochenen Kalibriermodule auszulesen und/oder auszuwerten, und
eine Speichereinrichtung, die dazu ausgebildet ist, die ausgelesenen und/oder ausgewerteten Informationen abzuspeichern.

12. System nach Anspruch 11,
**dadurch gekennzeichnet,**
**dass** die Adressiereinrichtung dazu ausgebildet ist, Adressen von über die serielle Busschnittstelle angekoppelten Kalibriermodulen auszulesen und/oder den über die serielle Busschnittstelle angekoppelten Kalibriermodulen jeweils eine individuelle, dynamische Adresse zuzuweisen.

13. System nach Anspruch 11 oder 12, **dadurch gekennzeichnet,**
**dass** die Analyseeinrichtung dazu ausgebildet ist, einen Impedanzwert und/oder eine Prüfsumme eines jeweiligen Impedanzwertes aus einem über die serielle Busschnittstelle angekoppelten Kalibriermodul auszulesen, und/oder dass eine Anzeigevorrichtung vorhanden ist, die dazu ausgebildet ist, eine Information der über die serielle Busschnittstelle angekoppelten Kalibriermodule, deren Status und/oder deren Betriebsmodi anzuzeigen.

14. Kalibrier- und Mess-System,
mit einem System nach einem der Ansprüche 11 bis 13,
mit mindestens zwei Inline Kalibriermodulen nach einem der Ansprüche 1 bis 8, die über deren Busschnittstelle und mittels eines seriellen Busses miteinander und mit der Programm-gesteuerten Einrichtung gekoppelt sind.

15. System nach Anspruch 14,
**dadurch gekennzeichnet,**
**dass** ein Netzwerkanalysator vorhanden ist, der über eine Vielzahl von Messleitungen mit jeweiligen Eingängen der Kalibriermodule verbunden ist und der in einem ersten Betriebsmodus dazu ausgebildet ist, durch die Kalibriermodule kalibriert zu werden.

## Claims

1. An inline calibration module for dynamic scattering parameter test system calibration in a test environment,
having at least three switchable calibration impedances independent from one another having in each case a predetermined impedance value, in each case designating calibration standards independent from one another,
having an output, which is configured to couple the calibration module to a device to be tested,
having a control input configured as a serial bus interface, which is configured to couple the calibration module for the control of same to an external controller.

2. The calibration module according to claim 1,
**characterized in that**
the serial bus interface is a CAN bus interface or a USB bus interface.

3. The calibration module according to any of the foregoing claims,
**characterized in that**
a memory device is present, in which the predetermined impedance values and/or an identification of the calibration module are stored.

4. The calibration module according to claim 3,
**characterized in that**
the storage device is further configured to store calibration information determined by the calibration module and/or address information received via a connected bus.

5. The calibration module according to any of the foregoing claims,
**characterized in that**
the three calibration impedances that are independent from one another designate Open, Short and Match, and/or that the calibration standards are configured to consider environmental influences, and/or that at least one further calibration impedance with in each case one predetermined impedance value is present, which supports a further calibration standard independent from the respective three calibration standards.

6. The calibration module according to any of the foregoing claims,
**characterized in that**
an integrated switchable power detector is present.

7. The calibration module according to any of the foregoing claims,
**characterized in that**
a display device, in particular a display, is present, which is configured to display ID information of the calibration module, bus addressing information, received or measured calibration data and/or information about the respective used calibration standard, and/or that an input device, in particular a key or a keyboard is present, which is configured to input status information about a currently used calibration process and/or information about the respective used calibration standard.

8. The calibration module according to any of the foregoing claims,
**characterized in that**
the calibration module has a metallic housing structure, which is configured in such a way that it is stress-resistant under test conditions.

9. The calibration module according to any of the foregoing claims,
**characterized in that**
an input is present, which is configured to couple the calibration module to a network analyzer for a scattering parameter test system calibration.

10. The calibration module according to claim 9,
**characterized in that**
the calibration module has, in addition to the switchable calibration impedances, a switchable through connection between the input and the output, **in that** in particular a controllable switching device is present, which in a first operating mode alternately connects the calibration impedances to the input and which in a second operating mode connects the input to the output via the through connection.

11. A system comprising a calibration module according to any of claims 1 to 8 and a programmable device for controlling the calibration module,
wherein the calibration module has an input which is configured to couple the calibration module to a network analyzer for a scattering parameter test system calibration, and
wherein the calibration module has, in addition to the switchable calibration impedances, a switchable through connection between the input and the output, and wherein in particular a controllable switching device is present, which in a first operating mode alternately connects the calibration impedances to the input and which in a second operating mode connects the input to the output via the through connection,
wherein the programmable device comprises the following:
a control interface configured as a serial bus interface,
a control unit, which is configured to control a plurality of calibration modules in daisy chain arrangement coupled to the programmable device via the control interface, wherein the control unit has an addressing device, which is configured to address the calibration modules coupled via the serial bus interface,
an analysis device, which is configured to read and/or evaluate information of the respective addressed calibration modules, and
a memory device, which is configured to store the read and/or evaluated information.

12. The system according to claim 11,
**characterized in that**
the addressing device is configured to read out addresses from calibration modules coupled via the serial bus interface and/or to assign in each case an individual, dynamic address to the calibration modules coupled via the serial bus interface.

13. The system according to claim 11 or 12,
**characterized in that**
the analysis device is configured to read out an impedance value and/or a checksum of a respective impedance value from a calibration module coupled via the serial bus interface, and/or in that a display device is present, which is configured to display information of the calibration modules coupled via the serial bus interface, their status and/or their operating modes.

14. A calibration and measurement system,
having a system according to any of claims 11 to 13,
having at least two inline calibration modules according to any of claims 1 to 8, which are coupled to each other and to the programmable device via their bus interface and by means of a serial bus.

15. The system according to claim 14,
**characterized in that**
a network analyzer is present, which is connected to the respective inputs of the calibration modules via a plurality of measurement lines and which in a first operating mode is configured to be calibrated by the calibration module.

## Revendications

1. Module d'étalonnage *in situ* pour un étalonnage dynamique de système de contrôle de paramètres de répartition dans un environnement de test,
avec au moins trois impédances d'étalonnage commutables et indépendantes les unes des autres avec respectivement une valeur d'impédance prédéterminée, qui désignent des références d'étalonnage respectivement indépendantes les unes des autres,
avec une sortie qui est conçue pour coupler le module d'étalonnage avec un appareil à tester,
avec une entrée de commande conçue en tant qu'interface de bus sérielle qui est conçue pour commander le module d'étalonnage en vue de coupler celui-ci avec un équipement de commande extérieur.

2. Module d'étalonnage selon la revendication 1,
**caractérisé en ce que**
l'interface de bus sérielle est une interface de bus CAN ou une interface de bus USB.

3. Module d'étalonnage selon l'une des revendications précédentes,
**caractérisé en ce que**
un équipement de stockage est en place, dans lequel les valeurs d'impédance prédéterminées et/ou une identification du module d'étalonnage sont déposées.

4. Module d'étalonnage selon la revendication 3,
**caractérisé en ce que**
l'équipement de stockage est en outre conçu pour enregistrer des informations d'étalonnage établies par le module d'étalonnage et/ou des informations d'adresse recueillies via un bus raccordé.

5. Module d'étalonnage selon l'une des revendications précédentes,
**caractérisé en ce que**
les trois impédances d'étalonnage indépendantes les unes des autres désignent les références circuit ouvert, court-circuit et charge adaptée, et/ou **en ce que** les références d'étalonnage sont conçues pour prendre en compte les effets environnementaux, et/ou **en ce qu'**au moins une autre impédance d'étalonnage est en place avec respectivement une valeur d'impédance prédéterminée qui soutient une autre référence d'étalonnage indépendante des trois références d'étalonnage respectives.

6. Module d'étalonnage selon l'une des revendications précédentes,
**caractérisé en ce que**
un détecteur de puissance commutable intégré est en place.

7. Module d'étalonnage selon l'une des revendications précédentes,
**caractérisé en ce que**
un dispositif d'affichage, en particulier un afficheur, est en place, lequel est conçu pour présenter des information ID du module d'étalonnage, des informations d'adressage de bus, des données d'étalonnage reçues ou mesurées et/ou des informations sur la référence d'étalonnage respectivement utilisée, et/ou **en ce qu'**un dispositif de saisie, en particulier une touche ou un clavier, est en place, lequel est conçu pour saisir des informations de statut sur un processus d'étalonnage en cours d'utilisation et/ou une information sur la référence d'étalonnage respectivement utilisée.

8. Module d'étalonnage selon l'une des revendications précédentes,
**caractérisé en ce que**
le module d'étalonnage présente une structure de boîtier métallique, laquelle est conçue de sorte qu'elle soit mécaniquement résistante au stress dans des conditions de test.

9. Module d'étalonnage selon l'une des revendications précédentes,
**caractérisé en ce que**
une entrée est en place qui est conçue pour coupler le module d'étalonnage avec un analyseur de réseau en vue d'un étalonnage de système de contrôle de paramètres de répartition.

10. Module d'étalonnage selon la revendication 9,
**caractérisé en ce que**
le module d'étalonnage présente, en plus des impédances d'étalonnage commutables, une interconnexion commutable entre l'entrée et la sortie, **en ce qu'**en particulier un dispositif de commutation qui peut être commandé est en place, lequel dans un premier mode d'exploitation relie alternativement les impédances d'étalonnage avec l'entrée et lequel dans un second mode d'exploitation relie l'entrée à la sortie via l'interconnexion.

11. Système qui comprend un module d'étalonnage selon l'une des revendications 1 à 8 et un équipement commandé par programme pour commander le module d'étalonnage,
dans lequel le module d'étalonnage présente une entrée qui est conçue pour coupler le module d'étalonnage avec un analyseur de réseau en vue d'un étalonnage de système de contrôle de paramètres de répartition, et
dans lequel le module d'étalonnage présente, en plus des impédances d'étalonnage commutables, une interconnexion commutable entre l'entrée et la sortie, et dans lequel en particulier un dispositif de commutation qui peut être commandé est en place, lequel dans un premier mode d'exploitation relie alternativement les impédances d'étalonnage avec l'entrée et lequel dans un second mode d'exploitation relie l'entrée avec la sortie via l'interconnexion,
dans lequel l'équipement commandé par programme comprend ce qui suit :
une interface de commande conçue en tant qu'interface de bus sérielle,
une unité de commande qui est conçue pour commander une pluralité de modules d'étalonnage couplés en un agencement en guirlande avec l'équipement commandé par programme via l'interface de commande, dans lequel l'unité de commande présente un équipement d'adressage qui est conçu pour appeler les modules d'étalonnage couplés via l'interface de bus sérielle,
un équipement d'analyse qui est conçu pour lire et/ou exploiter des informations des modules d'étalonnage respectivement appelés, et
un équipement de stockage qui est conçu pour enregistrer les informations lues et/ou exploitées.

12. Système selon la revendication 11,
**caractérisé en ce que**
l'équipement d'adressage est conçu pour lire des adresses de modules d'étalonnage couplés via l'interface de bus sérielle et/ou attribuer respectivement une adresse individuelle et dynamique aux modules d'étalonnage couplés via l'interface de bus sérielle.

13. Système selon la revendication 11 ou 12,
**caractérisé en ce que**
l'équipement d'analyse est conçu pour lire une valeur d'impédance et/ou une somme de contrôle d'une valeur d'impédance respective depuis un module d'étalonnage couplé via l'interface de bus sérielle, et/ou **en ce qu'**un dispositif d'affichage est en place qui est conçu pour afficher une information sur les modules d'étalonnage couplés via l'interface de bus sérielle, leur statut et/ou leurs modes d'exploitation.

14. Système d'étalonnage et de mesure,
avec un système selon l'une des revendications 11 à 13,
avec au moins deux modules d'étalonnage *in situ* selon l'une des revendications 1 à 8, qui sont couplés l'un avec l'autre et avec l'équipement commandé par programme via leur interface et au moyen d'un bus sériel.

15. Système selon la revendication 14,
**caractérisé en ce que**
un analyseur de réseau est en place qui est relié avec des entrées respectives des modules d'étalonnage via une pluralité de lignes de mesure et qui dans un premier mode d'exploitation est conçu pour être étalonné par les modules d'étalonnage.
